# EUROPEAN PATENT APPLICATION

(11) **EP 4 350 759 A1**
(43) Date of publication of application: **10.04.2024**
(21) Application number: 22200129.9
(22) Date of filing: 06.10.2022
(51) Int. Cl.: H01L 23/31, H01L 23/495

(54) **A SEMICONDUCTOR DEVICE**

(71) Applicant: Nexperia B.V., 6534 AB Nijmegen (NL)
(72) Inventor: Habenicht, Sönke, 22529 Hamburg (DE); Then, Nam Khong, Seremban (MY); Funke, Hans-Juergen, 22529 Hamburg (DE)
(74) Representative: Pjanovic, Ilija

(57) **Abstract**

The present disclosure relates to a semiconductor device. It is comprised of a lead frame, a semiconductor chip, a mold, and at least one adhesion promoter, wherein the lead frame comprises a first frame surface and a second frame surface opposite the first frame surface, and wherein the semiconductor chip comprises a first chip surface and a second chip surface opposite the first chip surface, wherein the first frame surface of the lead frame is an outer surface of the semiconductor device, with the second frame surface of the lead frame attached to the first chip surface of the semiconductor chip such, that the second frame surface of the lead frame is partially covered by the first chip surface of the semiconductor chip, wherein an uncovered surface part of the second frame surface of the lead frame and the second chip side of the semiconductor chip are in direct or indirect contact with the mold by means of the adhesion promoter, wherein the at least one adhesion promoter is on the uncovered surface part of the second frame surface of the lead frame and/or on the second chip surface of the semiconductor chip, wherein each of the adhesion promoter is optimized to enhance adhesion between the mold, and either the second frame surface of the lead frame or the second chip surface of the semiconductor chip.

## Description

### TECHNICAL FIELD

The present disclosure relates to a semiconductor device formed as a package comprising a lead frame, a semiconductor chip mounted to the lead frame and a mold encapsulating the lead frame and the semiconductor chip.

### BACKGROUND OF THE DISCLOSURE

Silicon Carbide (SiC) power devices are confronted with various requirements like high voltage (HV) ruggedness and moisture resistivity.

Often, these requirements are difficult to fulfill in combination, since HV requirements restrict the usage of encapsulating mold compounds to very few usable materials, which are exceedingly difficult to combine with the various material spectrum which is in use for SiC product architecture.

This includes the lead frame and lead frame plating materials, the die attach materials like Pb-based soft solder or Ag-sintering pastes, the wafer passivation material like polyimide and Silicon nitride and silicon oxide as well as the power metal stack used for bonding including Al, AlSiCu and TiNiAg. As these materials all have quite different properties like thermal expansion, adhesion properties like surface polarity and roughness., it is exceedingly difficult to find a material combination which fulfills the requirements of sufficient adhesion and hermeticity against humidity and moisture. For this reason, a MSL level 1 certification for moisture resistivity is hardly never applied for these devices.

Document TW200305621A discloses a method of coating a semiconductor substrate material with a coating material consisting of the steps of mixing an adhesion promoter with a coating material and applying the mixture to a semiconductor substrate material. The disclosure also includes means for coating a semiconductor substrate material with a coating material comprising means for mixing adhesion promoters with coating materials and means for applying the mixture of adhesion promoters and coating materials to a semiconductor substrate.

Document US4832996A discloses a semiconductor die for plastic encapsulation having an adhesion promoter selectively disposed on an outer surface enabling better adhesion between the semiconductor die and a plastic encapsulation. The improved adhesion allows for less relative motion between the semiconductor die and the plastic encapsulation. The reduction of relative motion significantly decreases the delamination progression throughout the semiconductor device and allows for an increased semiconductor device lifetime.

Document WO2007136428A2 discloses a semiconductor device with semiconductor device components embedded in a plastics composition is disclosed. In one embodiment, organosilicon and organometallic compounds are used for producing an adhesion promoter layer. The adhesion promoter layer on the surfaces of the semiconductor device components of a semiconductor device has a microporous morphology and has an average thickness D of between 5 nm ≦ D ≦ 300 nm. In this case, the adhesion promoter layer has nanoscale ceramic grains applied wet-chemically.

The object of the present disclosure is to control and optimize the adhesion of the mold compound to the different materials of the layer stack as well as the adhesion of different chip layers (e.g. passivation layers, polyimide) on each other and therefore ensure a proper adhesion of the mold compound on all interfaces of the product architecture as well as the adhesion of different chip layers on each other.

### SUMMARY OF THE DISCLOSURE

According to the disclosure, a semiconductor device is proposed, comprising a lead frame, a semiconductor chip, a mold, and at least one adhesion promoter. The lead frame comprises a first frame surface and a second frame surface opposite the first frame surface, and the semiconductor chip comprises a first chip surface and a second chip surface opposite the first chip surface. The first frame surface of the lead frame is an outer surface of the semiconductor device, with the second frame surface of the lead frame attached to the first chip surface of the semiconductor chip such, that the second frame surface of the lead frame is partially covered by the first chip surface of the semiconductor chip.

An uncovered surface part of the second frame surface of the lead frame and the second chip side of the semiconductor chip are in direct or indirect contact with the mold by means of the adhesion promoter. The at least one adhesion promoter is on the uncovered surface part of the second frame surface of the lead frame and/or on the second chip surface of the semiconductor chip. Each of the at least one adhesion promoter is optimized to enhance adhesion between the mold, and either the second frame surface of the lead frame or the second chip surface of the semiconductor chip.

Preferably the adhesion promoter consists of at least one selected from the group of silane based adhesion promoter, metal oxide dendrite coating, brown/black oxide, or PI-based adhesion promoter.

Preferably the semiconductor chip comprises, on the second chip surface, a passivation, on which a polyimide is placed, and wherein a third adhesion promoter is between the passivation and the polyimide.

According to another aspect of the disclosure, a method of manufacturing a semiconductor device is proposed, with the method comprising steps of: a) providing a semiconductor chip mounted to a lead frame, wherein the lead frame comprises a first frame surface and a second frame surface, and wherein the semiconductor chip comprises a first chip surface and a second chip surface, wherein the second frame surface of the lead frame is attached to the first chip surface of the semiconductor chip such that the second frame surface of the lead frame is partially covered by the first chip surface of the semiconductor chip, b) applying an adhesion promoter on an uncovered surface part of the second frame surface of the lead frame and/or on the second chip surface of the semiconductor chip, c) encapsulating the lead frame and the semiconductor chip in a mold such that the first frame surface of the lead frame forms an outer surface of the semiconductor device.

In a preferred example of the disclosure, the application of the adhesion promoter during step b) is performed by spraying.

Preferably, according to the disclosure, for each application of a different adhesion promoter a mask is used to ensure application of the adhesion promoter only on the desired surfaces.

In preferred examples, the adhesion promoter consists of at least one selected from the group of silane based adhesion promoter, metal oxide dendrite coating, brown/black oxide, or PI-based adhesion promoter.

Additionally, during step a) a third adhesion promoter is applied on a passivation on the second chip surface of the semiconductor chip, and followed by placing a polyimide on the passivation.

Furthermore the disclosure also pertains to the use of a semiconductor device in a high voltage electrical application e.g. high voltage traction inverter circuits in battery electric vehicles or switch mode power supplies.

### BRIEF DESCRIPTION OF THE DRAWINGS

The disclosure will now be discussed with reference to the drawings, which show in:
Figure 1 an example of a semiconductor device according to the state of the art;
Figure 2 a method of manufacturing the known semiconductor device disclosed in figure 1;
Figures 3 and 4 a semiconductor device according to an example of the disclosure;
Figure 5 an example of a method of manufacturing the semiconductor device disclosed in figure 3;
Figure 6 a detail of the method of manufacturing the semiconductor device disclosed in figure 5;
Figure 7 another example of a semiconductor device according to the disclosure;
Figure 8 an example of a method according to the disclosure of manufacturing the semiconductor device disclosed in figure 7;
Figure 9 another example of a semiconductor device according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

### Prior art example

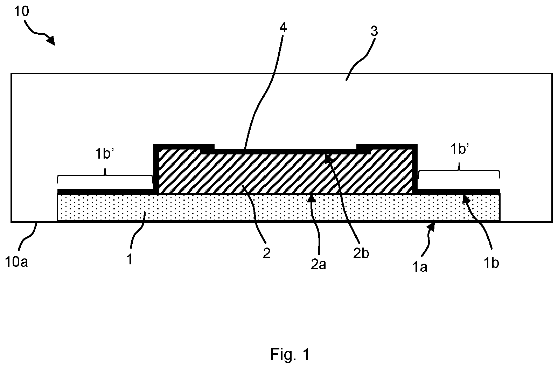

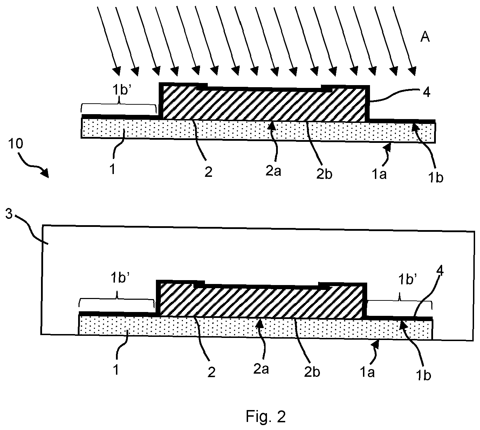

Fig. 1 together with Fig. 2 show the basic idea of an example of a manufacturing technology known in the prior art.

A typical SiC semiconductor device 10 according to the state of the art is assembled on a metal lead frame 1 and encapsulated with a mold compound 3 which seals the semiconductor chip 2 from the outer environment.

Between the surface of the SiC semiconductor chip 2 and the mold compound 3, there is a thin layer of chemical layer processed on the interfaces of the product architecture, i.e. a second chip surface 2b, an uncovered surface part 1b' of the second frame surface 1b and internal interconnects to the outer pins of the package, namely the wire or clip interconnects (not shown on figures). This thin chemical layer is an adhesion promoter 4 which increases the adhesion of the mold compound 3 to the underlying materials and surfaces.

In Fig 2, it can be seen how the adhesion promoter 4 is processed onto the semiconductor chip 2 and lead frame 1. Prior to the overmold process, the chemical layer is sprayed onto the second chip surface 2b and the uncovered surface part 1b' of the second frame surface 1b. After the spray process, the overmold process can start and the adhesion of the mold compound to the surfaces and materials is significantly enhanced.

### First example according to the disclosure:

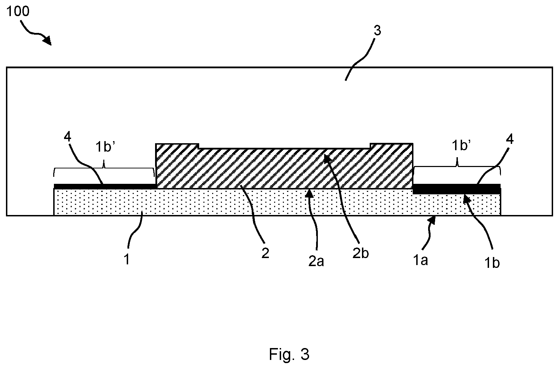

In Fig. 3, a first example of a semiconductor device 100 according to the disclosure is depicted. In this example of product architecture, the chemical layer providing the adhesion promotion property is only processed on certain parts of the underlying surfaces and materials, in this case only on the uncovered surface part 1b' of the second frame surface 1b. Therefore, only in these areas the adhesion promotion property is applied. This example of the disclosure can be applied in cases where the adhesion promoter 4 is only functional on certain interfaces, e.g. only at the interface between lead frame 1 and mold 3 and not effective or even contra-productive at other interfaces like e.g. the interface between the polyimide and the mold compound 3.

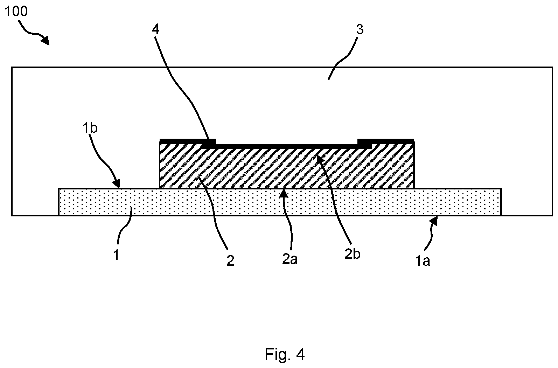

However, for certain adhesion promoter materials, it may be better to place it only on the second chip surface 2b of semiconductor chip 2. In that case, only the second chip surface 2b of semiconductor chip 2 is covered with the adhesion promoter 4, as shown in Fig. 4.

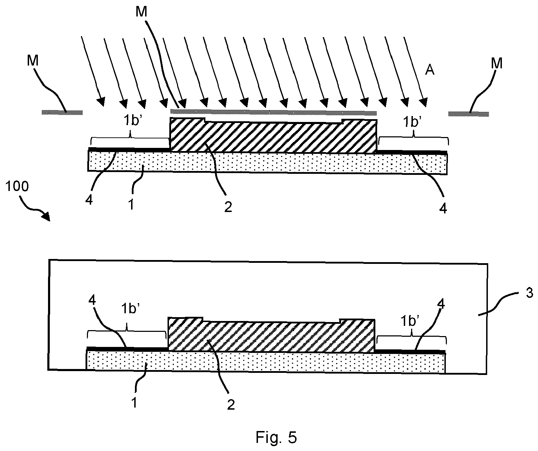

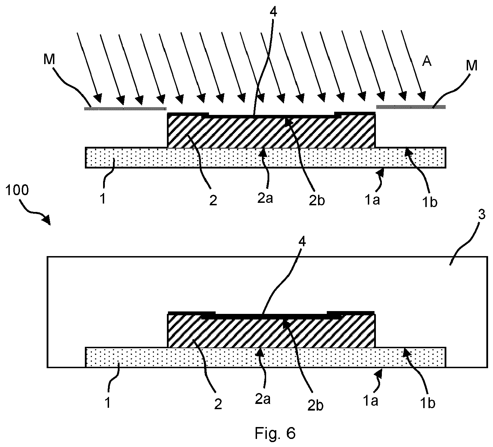

Fig. 5 shows an example of the processing of such a layer structure according to the disclosure. The adhesion promoter 4 is sprayed through an aperture in a mask M which ascertains or controls the chemical layer to be sprayed only onto the surfaces of interest, in this case the uncovered surface part 1b' of the second frame surface 1b. An example of a similar processing is shown in Fig. 6, where the adhesion layer 4 is sprayed only on the second chip surface 2b.

### Second example according to the disclosure:

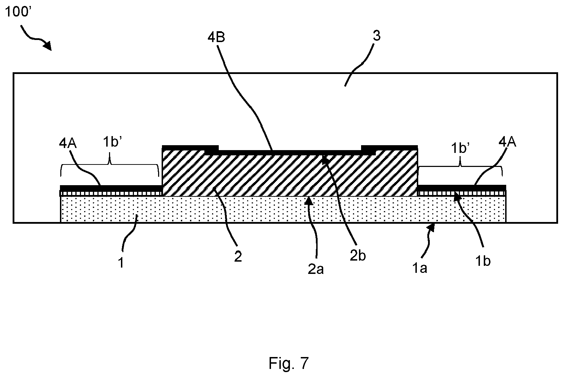

In Fig. 7, a second example of a semiconductor device 100' according to the disclosure is shown. In this product architecture, the first adhesion promoter 4a providing the adhesion promotion property is only processed on certain parts of the underlying surfaces and materials, in this case only the uncovered surface part 1b' of the second frame surface 1b. Therefore, only in these areas the adhesion promotion property is applied. This example may be applied in cases that the first adhesion promoter 4a is only functional on certain interfaces, e.g. only the interface between lead frame 1 and mold compound 3 and not effective or even contra-productive to other interfaces like the e.g. the polyimide and the mold compound 3.

In addition, a second adhesion layer 4b providing the adhesion promotion property on a different surface/mold stack 3 is only processed on different parts of the underlying surfaces and materials, in this case only the second chip surface 2b is covered with e.g. polyimide. Therefore, only in these areas the adhesion promotion property for the second adhesion layer 4b is applied.

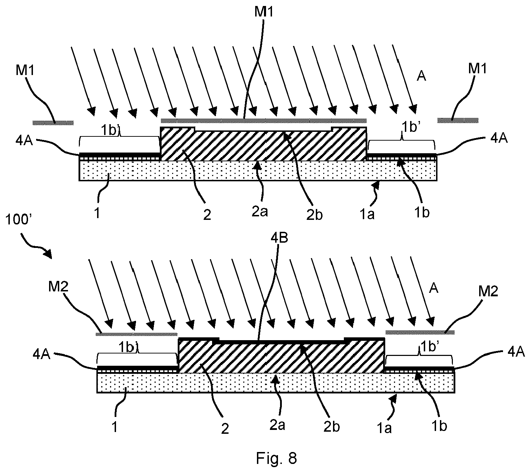

Fig. 8 shows the typical processing of such a layer structure according to the disclosure. The first adhesion promoter 4a is sprayed through an aperture of a first mask M1 which controls the first adhesion layer 4a to be sprayed only onto the surfaces of interest - in this example on the uncovered surface part 1b' of the second frame surface 1b. In a second step, the second adhesion promoter 4b is sprayed through an aperture of a second mask M2 which controls the second adhesion layer 4b to be sprayed only onto a different surface of interest - in this case the second chip surface 2b. This process flow can be extended with several adhesion promoter chemical layers and several subsequent process steps with different chemicals and different apertures to optimize the different material/mold 3 interfaces.

### Third example according to the disclosure:

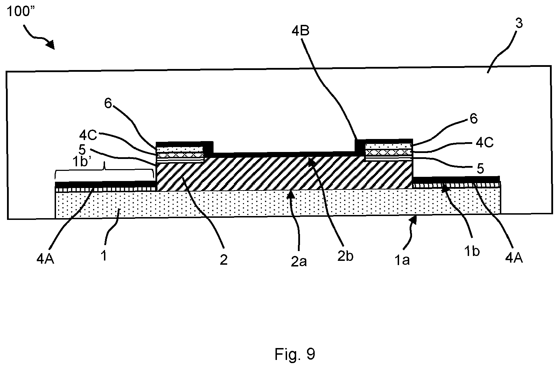

Fig. 9 show a third embodiment of a semiconductor device 100" according to the disclosure.

A SiC semiconductor device 100" is assembled on a metal lead frame 1 and encapsulated with a mold 3 which seals the semiconductor chip 2 from the outer environment. In addition to the basic disclosure of applying an adhesion promoter step between mold 3 and the underlying chip 2 and lead frame 1, there is also an adhesion layer 4c arranged on the passivation 5 to promote the adhesion either between the passivation 5 and the mold compound 3 or between the passivation 5 and the polyimide 6 to ensure a proper robustness of the underlying layer structure. This adhesion layer 4c can also be structured in such a way that the adhesion property can be controlled between different interfaces.

The adhesion layer 4c can be arranged either using the same spray technique using in the first example or it can be processed within the layer formation of the underlying passivation layers within a deposition and lithography step.

In each example a semiconductor chip 2, which is already mounted to a lead frame 1, is provided for further steps. Next an adhesion promoter 4, 4a, 4b, 4c is applied on desired surface as shown on a first, second and third example. After that, the lead frame 1 and the semiconductor chip 2 are encapsulated in a mold such that the first frame surface 1a of the lead frame 1 forms an outer surface 10a of the semiconductor device.

It should be noted that the adhesion promoter 4, 4a, 4b, 4c may be one of the mentioned from the group of silane based adhesion promoters, metal oxide dendrite coatings, brown/black oxides, or PI-based adhesion promoters.

The class of silane based adhesion promoters improves the adhesion of Cu-lead frames, and sometimes also AI-bond pad and polyimide chip coating to mold compounds. Such promoters are applied by spraying or dispensing. Examples are for example marketed under the tradenames Dupont AP8000, Fujifilm QZ3289 or Aculon AP.

Metal oxide dendrite coating is used for improving the adhesion by roughening the surface. It is applied by electrolytic type processes, and it is also known as nanobonding.

The use of brown/black coating NEAP has proven to improve the adhesion of mold to Cu and Ag-surfaces. It is preferred to pre-coat it on incoming bare lead frame/clip frame parts or during the immersion process. Suitable examples are known as Atotech mold prep, Dupont brown oxide or Atotech NEAP for copper surfaces.

The class of Pi-based adhesion promoter (HIMAL) provide a better adhesion to Ni-surfaces, SiC, etc. It is applied be spraying or dispensing. An examples is for example known under the trade name Showa Denko Himal.

It should be noted that the examples also extent to all combinations of the examples mentioned above.

### LIST OF REFERENCE NUMERALS USED

- 1: lead frame
- 1a: first frame surface of lead frame 1
- 1b: second frame surface of lead frame 1
- 1b': uncovered surface part of the second frame surface 1b of the lead frame 1
- 2: semiconductor chip
- 2a: first chip surface of semiconductor chip 2
- 2b: second chip surface of semiconductor chip 2
- 3: mold
- 4: adhesion promoter
- 4a: first adhesion promoter
- 4b: second adhesion promoter
- 4c: third adhesion promoter
- 5: passivation
- 6: polyimide
- M: mask
- M1: first mask
- M2: second mask
- 10: semiconductor device (state of the art)
- 10a: outer surface of semiconductor device
- 100: semiconductor device (first example of the disclosure)
- 100': semiconductor device (second example of the disclosure)
- 100": semiconductor device (third example of the disclosure)

## Claims

1. A semiconductor device (10) comprising:
a lead frame (1),
a semiconductor chip (2),
a mold (3), and
at least one adhesion promoter (4, 4a, 4b, 4c),
wherein the lead frame (1) comprises a first frame surface (1a) and a second frame surface (1b) opposite the first frame surface (1a), and
wherein the semiconductor chip (2) comprises a first chip surface (2a) and a second chip surface (IV) opposite the first chip surface (2a),
wherein the first frame surface (1a) of the lead frame (1) is an outer surface (10a) of the semiconductor device (10), with the second frame surface (1b) of the lead frame (1) attached to the first chip surface (2a) of the semiconductor chip (2) such, that the second frame surface (1b) of the lead frame (1) is partially covered by the first chip surface (2a) of the semiconductor chip (2),
wherein an uncovered surface part (II') of the second frame surface (1b) of the lead frame (1) and the second chip side (2b) of the semiconductor chip (2) are in direct or indirect contact with the mold (3) by means of the adhesion promoter (4, 4a, 4b, 4c),
wherein the at least one adhesion promoter (4, 4a, 4b, 4c) is on the uncovered surface part (II') of the second frame surface (1b) of the lead frame (1) and/or on the second chip surface (2b) of the semiconductor chip (2),
wherein each of the adhesion promoter (4, 4a, 4b, 4c) is optimized to enhance adhesion between the mold (3), and either the second frame surface (1b) of the lead frame (1) or the second chip surface (2b) of the semiconductor chip (2).

2. The semiconductor device according to claim 1, wherein the adhesion promoter (4, 4a, 4b, 4c) consists of at least one selected from the group of silane based adhesion promoter, metal oxide dendrite coating, brown/black oxide, or PI-based adhesion promoter.

3. The semiconductor device according to claim 1 or 2, wherein the semiconductor chip (2) comprises, on the second chip surface (2b), a passivation (5), on which a polyimide (6) is placed, and wherein a third adhesion promoter (4c) is between the passivation (5) and the polyimide (6).

4. A method of manufacturing a semiconductor device according to any one or more of the claims 1-3, comprising steps of:
a) providing a semiconductor chip (2) mounted to a lead frame (1), wherein the lead frame (1) comprises a first frame surface (1a) and a second frame surface (1b), and wherein the semiconductor chip (2) comprises a first chip surface (2a) and a second chip surface (2b), wherein the second frame surface (1b) of the lead frame (1) is attached to the first chip surface (2a) of the semiconductor chip (2) such that the second frame surface (1b) of the lead frame (1) is partially covered by the first chip surface (2a) of the semiconductor chip (2),
b) applying an adhesion promoter (4, 4a, 4b, 4c) on an uncovered surface part of the second frame surface (1b) of the lead frame (1) and/or on the second chip surface (2b) of the semiconductor chip (2),
c) encapsulating the lead frame (1) and the semiconductor chip (2) in a mold such that the first frame surface (1a) of the lead frame (1) forms an outer surface of the semiconductor device.

5. The method according to claim 4, wherein the application of the adhesion promoter (4, 4a, 4b, 4c) during the step b) is performed by spraying.

6. The method according to claim 4 or 5, wherein, for each application of a different adhesion promoter (4, 4a, 4b, 4c) a mask (M, M1, M2) is used to ensure application of the adhesion promoter (4, 4a, 4b, 4c) on desired surfaces only.

7. The method according to anyone of claim 4-6, wherein the adhesion promoter (4, 4a, 4b, 4c) consists of at least one selected from the group of silane based adhesion promoter, metal oxide dendrite coating, brown/black oxide, or PI-based adhesion promoter.

8. The method according to anyone of claim 4-7, wherein during the step a) a third adhesion promoter (4c) is applied on a passivation (5) on the second chip surface (IV) of the semiconductor chip (2), and followed by placing a polyimide (6) on the passivation (5).

9. The use of a semiconductor device according to anyone of claims 1-3 in a high voltage electrical application.
